# EUROPEAN PATENT APPLICATION

(11) **EP 4 794 457 A1**
(43) Date of publication of application: **19.08.2026**
(21) Application number: 26157501.3
(22) Date of filing: 10.02.2026
(51) Int. Cl.: H05K 1/09, H05K 1/03, H05K 3/12, H05K 3/22

(54) **METHOD FOR MANUFACTURING CONDUCTIVE FILM AND CONDUCTIVE FILM**

(30) Priority: 14.02.2025 JP 2025022195; 12.12.2025 JP 2025247547
(71) Applicant: Ricoh Company, Ltd., Tokyo 143-8555 (JP)
(72) Inventor: MATSUMOTO, Shinji, Ohta-ku, 143-8555 (JP); FUJITA, Takashi, Ohta-ku, 143-8555 (JP); TAKEUCHI, Kohji, Ohta-ku, 143-8555 (JP); UNNO, Hirotaka, Ohta-ku, 143-8555 (JP)
(74) Representative: J A Kemp LLP

(57) **Abstract**

A method for manufacturing a conductive film is provided. The method includes: forming a layered structure (6) by repeating forming a print pattern by applying an ink (20) containing copper and copper hydride onto a substrate (1), and forming a dried film (22) by heating the print pattern and blowing air onto the print pattern; and sintering the layered structure (6).

## Description

### BACKGROUND

### Technical Field

The present disclosure relates to a method for manufacturing a conductive film and a conductive film.

### Related Art

In recent years, printed electronics have been attracting attention. Printed electronics allow for manufacturing without requiring exposure or etching processes used in conventional printed circuit board fabrication methods, and without discharging harmful chemical substances. One example thereof is a conductive film obtained by drawing a wiring pattern of conductive ink on a substrate using an existing printing technology (e.g., inkjet printing).

For example, a method for forming a conductive pattern by sintering an ink formulation containing copper nanoparticles, a copper oxidizing agent, and CuH in an air atmosphere is disclosed (see, for example, Japanese Translation of PCT International Application Publication No. JP-T-2019-529587 and Lousada CM, Fernandes RMF, Tarakina NV, Soroka IL. Synthesis of copper hydride (CuH) from CuCO₃ Cu(OH)₂ a path to electrically conductive thin films of Cu. Dalton Trans. 2017 May 23;46(20):6533-6543. doi: 10.1039/c7dt00511c. PMID: 28379275).

### SUMMARY

The present disclosure described herein provides a method for manufacturing a conductive film, by which a conductive film having low resistance and suppressed non-uniformity in resistance can be manufactured with high formation accuracy and high productivity.

The method includes: forming a layered structure by repeating forming a print pattern by applying an ink containing copper and copper hydride onto a substrate, and forming a dried film by heating the print pattern and blowing air onto the print pattern; and sintering the layered structure.

According to one aspect of the present disclosure, a method for manufacturing a conductive film is provided, by which a conductive film having low resistance and suppressed non-uniformity in resistance can be manufactured with high formation accuracy and high productivity.

### BRIEF DESCRIPTION OF THE DRAWINGS

A more complete appreciation of embodiments of the present disclosure and many of the attendant advantages and features thereof can be readily obtained and understood from the following detailed description with reference to the accompanying drawings, wherein:
FIG. 1 is a diagram illustrating an apparatus for measuring electrical resistivity;
FIG. 2 is a diagram illustrating a relationship between a content ratio (mass ratio) of a solvent to a total amount of ink and conductivity (IACS);
FIG. 3 is a diagram illustrating a relationship between a penetration drying time T of a solvent and conductivity (IACS);
FIG. 4 is a diagram illustrating a relationship between a contact angle θ of ink with respect to a substrate and conductivity (IACS);
FIG. 5 is a diagram illustrating a relationship between a measured value and a predicted value of conductivity (IACS);
FIG. 6 is a schematic diagram for explaining a layered structure forming step; and
FIG. 7 is a schematic diagram for explaining a sintering step.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

Although copper used in conductive ink is low in cost, there is a concern that copper oxidizes, thereby readily resulting in increased resistance and inhibiting sintering. As one means for solving such a problem, there is disclosed a method in which copper hydride (CuH) is contained in conductive ink, thereby enhancing stability of copper and promoting sintering (see, for example, Japanese Translation of PCT International Application Publication No. JP-T-2019-529587 and Lousada CM, Fernandes RMF, Tarakina NV, Soroka IL. Synthesis of copper hydride (CuH) from CuCO₃ Cu(OH)₂ a path to electrically conductive thin films of Cu. Dalton Trans. 2017 May 23;46(20):6533-6543. doi: 10.1039/c7dt00511c. PMID: 28379275).

In general, the productivity of a conductive film can be increased by increasing an amount of ink applied or heating the ink at a high temperature. However, when the ink is heated at a high temperature, there is a concern that the copper hydride in the ink is decomposed, thereby inhibiting sintering and resulting in increased resistance of the conductive film.

Further, when the amount of ink applied is increased, there is also a concern that the ink applied onto a substrate flows, whereby the formation accuracy of the conductive film decreases and non-uniformity in resistance of the conductive film occurs.

The method for manufacturing a conductive film according to the present embodiment can sufficiently resolve various concerns in the related art. More specifically, a method for manufacturing a conductive film, by which a conductive film having low resistance and suppressed non-uniformity in resistance can be manufactured with high formation accuracy and high productivity, can be implemented by the method for manufacturing a conductive film according to the present embodiment.

Details of the present embodiment are described below.

### (Method for Manufacturing Conductive Film and Conductive Film Manufacturing Apparatus)

The method for manufacturing a conductive film according to the present embodiment includes a layered structure forming step and a sintering step, and may include other steps as necessary.

The conductive film manufacturing apparatus related to the present embodiment includes a layered structure forming means and a sintering means, and may include other means as necessary.

The method for manufacturing a conductive film can be suitably carried out by the conductive film manufacturing apparatus.

### <Layered Structure Forming Step and Layered Structure Forming Means>

The layered structure forming step is a step of repeating a print pattern forming step and a dried film forming step to form a layered structure.

The layered structure forming means includes a print pattern forming means and a dried film forming means.

The layered structure forming step can be suitably carried out by the layered structure forming means.

### <<Print Pattern Forming Step and Print Pattern Forming Means>>

The print pattern forming step is a step of applying ink containing copper and copper hydride (CuH) onto a substrate to form a print pattern.

The print pattern forming means is a means for applying ink containing copper and copper hydride (CuH) onto a substrate to form a print pattern.

The print pattern forming step can be suitably carried out by the print pattern forming means.

### <<<Substrate>>>

The material of the substrate is not particularly limited and can be appropriately selected depending on the purpose. Examples thereof include, but are not limited to, paper, glass, and heat-resistant synthetic resin.

The paper is not particularly limited and can be appropriately selected depending on the purpose. Examples thereof include, but are not limited to, coated paper and wrapping paper.

The "heat resistance" in the present specification preferably means a property in which a glass transition temperature is higher than a sintering temperature of the ink. Examples of the heat-resistant synthetic resin include, but are not limited to, polyimide, epoxy resin, polycarbonate, and fluororesin.

The shape of the substrate is not particularly limited and can be appropriately selected depending on the purpose. Examples thereof include, but are not limited to, a flat plate shape, a three-dimensional shape, and a film shape. Examples of the substrate having a three-dimensional shape include, but are not limited to, a semiconductor package.

The size, structure, and thickness of the substrate are not particularly limited and can be appropriately selected depending on the application.

From the viewpoint of removing deposits, oils and fats, and the like, the substrate is preferably cleaned on its ink application surface using pure water, a neutral detergent, or the like before applying the ink in the print pattern forming step. The cleaning method is not particularly limited and can be appropriately selected depending on the purpose. For example, an ultrasonic device may be used in combination.

From the viewpoint of improving adhesion with the ink, the substrate may be subjected to surface treatment before applying the ink in the print pattern forming step. Examples of the method of the surface treatment include, but are not limited to, a UV/O₃ method and atmospheric pressure plasma treatment.

The substrate may have permeability.

Conventionally, when ink is applied to a substrate having permeability, there is a concern that as the ink penetrates, components necessary for forming a metal film are separated, thereby inhibiting sintering and resulting in increased resistance. Although details will be described below, according to the layered structure forming step of the present embodiment, the print pattern is dried each time one layer is formed to form a dried film. Therefore, the lowermost dried film functions as a penetration prevention layer, thereby suppressing separation of components necessary for forming a metal film and making it possible to manufacture a conductive film having low resistance.

In the method for manufacturing a conductive film according to the present embodiment, it is desirable that a relationship between a solvent contained in the ink and the substrate satisfies the following Formula I. $θ ≦ 60.5 Log \left(T\right) - 264 Sw + 205$

In the above Formula I, Sw is a content ratio (mass ratio) of the solvent to the total amount of the ink, T is a penetration drying time (seconds) of the solvent with respect to the substrate, and θ is a contact angle (°) of the solvent with respect to the substrate.

Here, a method for deriving the above Formula I is described.

### (Tests A to L)

### <Preparation of Ink>

As copper, Cu nanoparticles (NP) were used. A method for preparing the Cu nanoparticles is described in detail in Venkata Abhinav et al., RSC Advances, 2015, 5, 63985-64030.

Copper NP dispersion liquid was washed with an ultrafiltration membrane (CO = 100 KDa, PES). Using diethylene glycol monomethyl ether as a solvent, a composition containing copper was prepared. The composition was filtered through a 1 µm syringe filter, and 1.6% by mass of hypophosphorous acid (HPA) was added thereto to prepare an ink.

The inks used in Tests A to D were prepared so that the content of the solvent was 70% by mass with respect to the total amount of the ink. The inks used in Tests E to H were prepared so that the content of the solvent was 55% by mass with respect to the total amount of the ink. The inks used in Tests I to L were prepared so that the content of the solvent was 20% by mass with respect to the total amount of the ink.

### [Preparation of Substrate]

For Tests A, E, and I, Gloss Coat (manufactured by Oji Paper Co., Ltd., OK Top Coat) and PVA Coat (manufactured by Oji Paper Co., Ltd.) were used as substrates.

For Tests B, F, and J, fluorine-free oil-proof paper (manufactured by Daio Paper Corporation, FS Oil-Proof Paper FF) was used as a substrate.

For Tests C, G, and K, glassine paper (manufactured by PAPER Entrance, Model No. 55064) was used as a substrate.

For Tests D, H, and L, oil-proof paper using a fluorine-containing oil-proofing agent (manufactured by Ishizaki Shoji Co., Ltd., Oil-Proof Paper T-8) was used as a substrate.

### [Printing by Inkjet Method]

The inks used in Tests A to H were printed by an inkjet method.

As an inkjet head, MH5420 manufactured by Ricoh Company, Ltd. was used. The print pattern was a solid image having a recording density of 1200 dpi × 1200 dpi and an image size of 30 mm × 30 mm, and was printed in 2 to 3 passes to obtain a film thickness of 3 µm. A stage was preheated so that the substrate surface temperature was set to 95°C.

### [Printing by Spin Coating Method]

Since the inks used in Tests I to L were in paste form, printing was performed by a spin coating method. Printing was performed on the substrate at 7,000 rpm so that a film thickness after drying and sintering was 3 µm.

### [Sintering]

A polyimide film (manufactured by Toray DuPont Co., Ltd., 200H) was pasted on the surface of the printed matter after drying, and the printed matter was placed on a hot plate heated to 230°C. Immediately thereafter, a weight of 2 kg was placed thereon, and sintering was performed for 60 seconds to obtain an electronic component of each test.

The conductivity (IACS: International Annealed Copper Standard) of each of the obtained electronic components was measured based on the following method. The results are illustrated in Tables 1 and 2.

### [Method for Measuring Conductivity (IACS)]

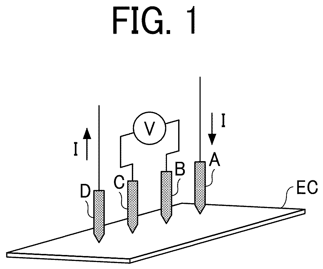

Measurement was performed according to a part of the resistivity test method by a four-probe method for conductive plastics specified in JIS K 7194:1994. As illustrated in FIG. 1, in the four-probe method, a current I was passed between AD in needles A to D placed on an electronic component EC of a sample, a potential difference V between BC was measured, and the ratio thereof was multiplied by a correction factor RCF to obtain a sheet resistance ρs. The value of 4.532, which is obtainable even when an infinite plane is assumed, was used as the RCF. A low resistivity meter Loresta MCP-T380 (manufactured by Nittoseiko Analytech Co., Ltd.), which is a simplified model, and a PSP probe with a pin interval of 1.5 mm were used.

Next, a film thickness t of the electronic component was measured from cross-sectional observation of the sample. At this time, three cross sections were measured, and an average value thereof was taken as the film thickness t.

Using the following Formula II, a volume resistivity ρv and conductivity, which is the reciprocal thereof, were calculated. Note that the conductivity (IACS) was determined by taking the conductivity of International Annealed Copper Standard (volume resistivity 1.7241 × 10⁻⁸ Ωm) as 100%. $ρ v = V / I \times RCF \times t = ρ s \times t$

**Table 1**

| | Test A | Test B | Test C | Test D | Test E | Test F |
|---|---|---|---|---|---|---|
| Substrate | OK Top Coat+ | FS Oil-Proof Paper FF | Glassine Paper | Oil-Proof Paper T-8 | OK Top Coat+ | FS Oil-Proof Paper FF |
| Content Ratio (Mass Ratio) of Solvent to Total Amount of Ink | 0.7 | 0.7 | 0.7 | 0.7 | 0.55 | 0.55 |
| Contact Angle θ (° ) | 28 | 59 | 20 | 115 | 28 | 59 |
| Penetration Drying T (s) | 0.21 | 19 | 7.8 | 22 | 0.21 | 19 |
| Conductivity (IACS) (%) | 1.3 | 12.0 | 26.6 | 4.9 | 4.7 | 24.6 |

**Table 2**

| | Test G | Test H | Test I | Test J | Test K | Test L |
|---|---|---|---|---|---|---|
| Substrate | Glassine Paper | Oil-Proof Paper T-8 | OK Top Coat+ | FS Oil-Proof Paper FF | Glassine Paper | Oil-Proof Paper T-8 |
| Content Ratio (Mass Ratio) Of Solvent to Total Amount of Ink | 0.55 | 0.55 | 0.2 | 0.2 | 0.2 | 0.2 |
| Contact Angle θ (° ) | 20 | 115 | 28 | 59 | 20 | 115 |
| Penetration Drying T(s) | 7.8 | 22 | 0.21 | 19 | 7.8 | 22 |
| Conductivity (IACS) (%) | 26.6 | 14.9 | 27.3 | 34.0 | 36.2 | 34.0 |

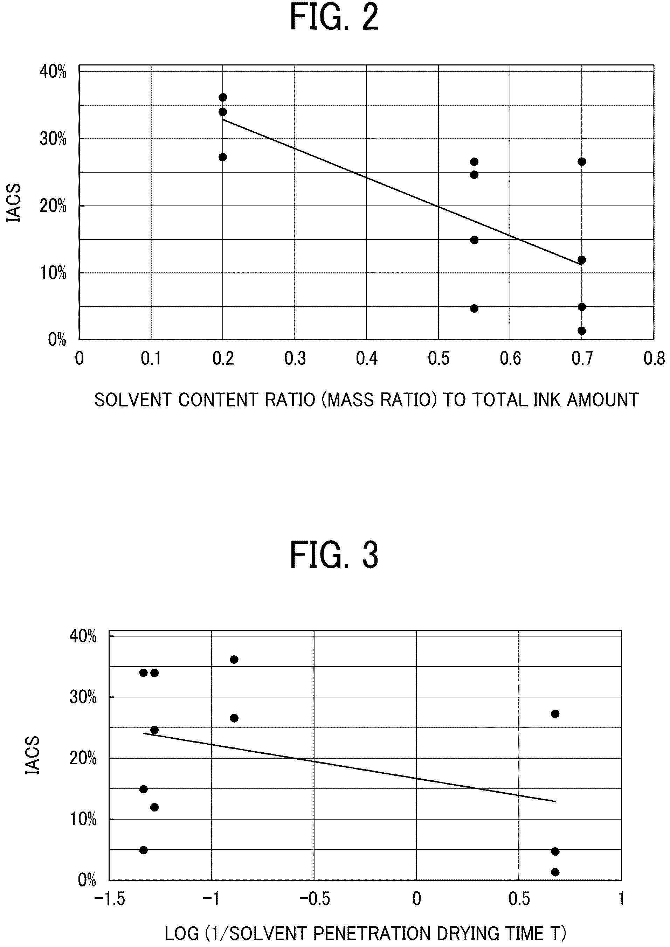

Based on the results of Tables 1 and 2, FIG. 2 illustrates a relationship between the content ratio (mass ratio) of the solvent to the total amount of the ink and IACS. From FIG. 2, a clear negative correlation was observed between the content ratio (mass ratio) of the solvent to the total amount of the ink and IACS. From this, it was hypothesized that components such as hypophosphorous acid, which are originally intended to remain within the ink film, migrate to the substrate together with the penetration of the solvent, thereby inhibiting sintering and resulting in increased resistance, and leading to decreased conductivity of the obtained electronic component. Based on this hypothesis, the relationship between the solvent and the substrate was further investigated.

First, the penetration drying time T of the solvent was investigated. The "penetration drying time T of the solvent" in the present specification indicates a time (seconds) until the solvent applied onto the substrate disappears from the substrate due to penetration and drying.

The penetration drying time T of the solvent was measured using a high-speed microscope camera (manufactured by Keyence Corporation, VW-6000) at 1000 frames per second, as the time until 30 pL of the solvent droplet applied onto the substrate disappeared from the substrate. The results are illustrated in Tables 1 and 2.

Based on the results of Tables 1 and 2, FIG. 3 illustrates a relationship between the penetration drying time T of the solvent and IACS.

From FIG. 3, a negative correlation was observed between the penetration drying time T of the solvent and IACS.

Next, in order to confirm a more microscopic interaction between the substrate and the solvent, the contact angle θ of the ink with respect to the substrate was measured with a contact angle meter DMs-301 (manufactured by Kyowa Interface Science Co., Ltd.). At this time, the droplet was 0.5 µL to 0.6 µL. The results are illustrated in Tables 1 and 2.

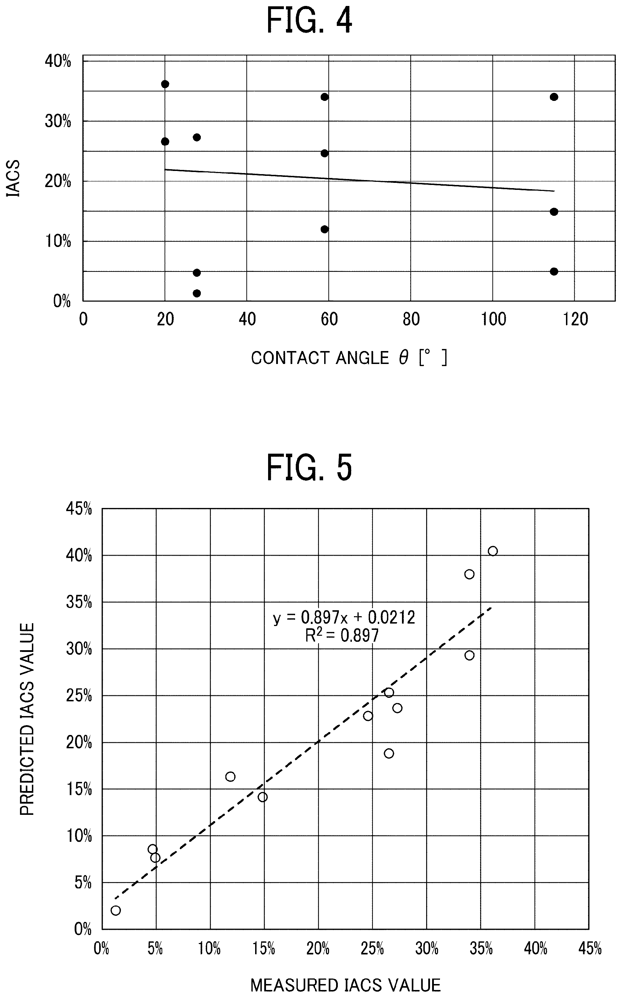

Based on the results of Tables 1 and 2, FIG. 4 illustrates a relationship between the contact angle θ of the ink with respect to the substrate and IACS. From FIG. 4, a negative correlation was observed between the contact angle θ of the ink with respect to the substrate and IACS.

In addition to the above, the correlation between the solvent and surface roughness of the substrate and the correlation between the solvent and thickness of the substrate were also investigated, but no correlation with IACS could be confirmed. Here, multiple regression analysis was performed using the respective measurement results obtained in Tests A to L, with a content ratio Sw (mass ratio) of the solvent in the total amount of the ink, the penetration drying time T (seconds) of the solvent, and the contact angle θ (°) as explanatory variables Xs. The results are illustrated in Table 3. Note that the multiple regression analysis illustrated in Table 3 satisfies the following conditions, indicating that the analysis is statistically valid.
- Adjusted R2 is 0.6 or greater.
- Significance F is 0.05 or less.
- The Absolute value of the t-statistic excluding the intercept is 2 or more.
- The P-value is 0.05 or less.

**Table 3**

| Regression Statistics | | | | | | | | |
|---|---|---|---|---|---|---|---|---|
| Multiple R | 0.94709952 | | | | | | | |
| Coefficient of determination R2 | 0.896997501 | | | | | | | |
| Adjusted R2 | 0.858371564 | | | | | | | |
| Standard Error | 4.69214036 | | | | | | | |
| Observations | 12 | | | | | | | |

| Analysis of Variance Table | | | | | | | | |
|---|---|---|---|---|---|---|---|---|
| | Degrees of Freedom | Sum of Squares | Mean Square | Observed F value | Significance F | | | |
| Regression | 3 | 1533.82372 | 551.2745733 | 23.22267289 | 0.000265338 | | | |
| Residual | 8 | 176.1294492 | 22.01618115 | | | | | |
| Total | 11 | 1709.953169 | | | | | | |
| | | | | | | | | |

| | Coefficients | Standard Error | t | P-value | Lower 95% | Upper 95% | Lower 95.0% | Upper 95.0% |
|---|---|---|---|---|---|---|---|---|
| Intercept | 43.62834856 | 3.955260046 | 11.03046274 | 4.06307E-06 | 34.50750254 | 52.74919458 | 34.50750254 | 52.74919458 |
| X Value 1 | -43.31281197 | 6.465514335 | -6.699051263 | 0.000152856 | -58.22231476 | -28.40330918 | -58.22231476 | -28.40330918 |
| X Value 2 | -9.937187177 | 2.04069905 | -4.869501546 | 0.001240756 | -14.64304762 | -5.23132673 | -14.64304762 | -5.23132673 |
| X Value 3 | -0.164320948 | 0.044628443 | -3.681978069 | 0.00620145 | -0.267234322 | -0.061407574 | -0.267234322 | -0.061407547 |

In Table 3, the X value 1 is the content ratio Sw (mass ratio) of the solvent in the total amount of the ink, the X value 2 is the logarithm of 1/the penetration drying time T (seconds) of the solvent, and the X value 3 is the contact angle θ (°).

From the results of Table 3, Formula III was obtained as a prediction formula that predicts conductivity based on the content ratio Sw (mass ratio) of the solvent in the total amount of the ink, the penetration drying time T (seconds) of the solvent, and the contact angle θ (°). $IACS Predicted value \left(%\right) = 43.6 - 43.3 Sw - 9.94 Log \left(T\right) - 0.164 θ$

FIG. 5 illustrates a relationship between the measured values obtained in the above Tests A to L and the predicted values calculated by Formula III. From FIG. 5, it was found that Formula III, which is the above prediction formula, enables almost accurate prediction of the conductivity.

In general, electronic components are considered to function sufficiently if IACS is 10% or more. From this, Formula I given below is derived by setting the left side of the above Formula III to 10% or more and transforming the formula. $θ ≦ 60.5 Log \left(T\right) - 264 Sw + 205$

In the print pattern forming step, heating of the print pattern is preferably performed in combination. In other words, when applying ink to the substrate, the substrate may be preheated. This can promote drying of the ink applied onto the substrate, thereby suppressing the flow of the ink, and, as a result, increasing the formation accuracy of the conductive film.

The heating means is not particularly limited and can be appropriately selected depending on the purpose. Examples thereof include, but are not limited to, a heating mechanism of a stage in the print pattern forming means.

The heating temperature of the substrate is not particularly limited and can be appropriately selected depending on the purpose, but is preferably 40°C or higher and 100°C or lower, and more preferably 55°C or higher and 75°C or lower.

When the heating temperature of the substrate is within these ranges, it eliminates issues such as an oxidizing agent and a reducing agent contained in the ink evaporating, which would otherwise hinder efficient progression of the sintering reaction during a subsequent sintering step.

As the substrate, an appropriately synthesized one may be used, or a commercially available product may be used.

Examples of the substrate include, but are not limited to, alkali-free glass substrates (manufactured by Corning Inc., Eagle XG, 40 mm × 40 mm × t0.7 mm), polyimide (manufactured by Toray DuPont Co., Ltd., Kapton H ("Kapton" is a registered trademark)), FS Oil-Proof Paper (manufactured by Daio Paper Corporation, FS Oil-Proof Paper FF), oil-proof paper (manufactured by Ishizaki Shoji Co., Ltd., T-8), glassine paper (manufactured by PAPER Entrance, Model No. 55064), and coated paper (manufactured by Daio Paper Corporation, Utrillo Coat L).

The substrate is preferably a medium having permeability. The medium having permeability is preferably paper, and among them, glassine paper is more preferable. Glassine paper is a type of paper, has smooth and translucent characteristics, and is mainly manufactured by mechanically compressing pulp for an extended period and subjecting the pulp to super-calendering. Through this manufacturing process, paper fibers are arranged very densely, resulting in a smooth surface of the paper and imparting a certain degree of water resistance and oil resistance. These characteristics are expected to have an effect of increasing the formation accuracy of the conductive film and an effect of preventing a decrease in conductive function by preventing penetration of ink components.

### <<<Ink>>>

The ink contains copper and copper hydride (CuH), and may contain a reducing agent, an oxidizing agent, and other components as necessary.

### -Copper-

The shape of copper is not particularly limited and can be appropriately selected depending on the purpose, and may be a fixed shape or an indefinite shape. Among these, a fixed shape is preferable. When the copper has a fixed shape, it is preferably spherical. When the shape of copper is spherical, it is preferably in particulate form.

A particle diameter (volume-average median diameter) of particulate copper (hereinafter sometimes referred to as "copper particles") is not particularly limited and can be appropriately selected depending on the purpose, but is preferably 10 nm or more and 1000 nm or less, and more preferably 10 nm or more and 200 nm or less.

A method for measuring a particle diameter is not particularly limited and can be appropriately selected depending on the purpose. For example, it can be measured by a particle size distribution analyzer based on light scattering, a particle size distribution analyzer based on centrifugal sedimentation, or the like.

The content of copper is not particularly limited and can be appropriately selected depending on the purpose, but is preferably 10% by mass or more and 90% by mass or less with respect to the total amount of the ink.

A method for measuring the content of copper is not particularly limited and can be appropriately selected depending on the purpose. For example, the content of copper can be measured by simultaneous thermogravimetry-differential thermal analysis (TG-DTA) or the like.

As the copper, an appropriately synthesized one may be used, or a commercially available product may be used. A method for synthesizing copper is not particularly limited and can be appropriately selected depending on the purpose. For example, copper may be synthesized based on the description in Venkata Abhinav et al., RSC Advances, 2015, 5, 63985-64030.

### -Copper Hydride (CuH)-

Copper hydride (CuH) reduces copper oxide contained in the ink and copper oxide generated during the sintering step. Specifically, in the sintering step, copper oxide contained in the dried film is reduced as copper hydride (CuH) decomposes, whereby sintering of copper proceeds readily and a conductive film having low resistance can be obtained. Note that copper hydride (CuH) is also generated during the sintering step by hypophosphorous acid, but copper hydride is contained in the ink in advance, thereby promoting the reduction reaction of copper oxide.

The content of copper hydride (CuH) is not particularly limited and can be appropriately selected depending on the purpose. However, from the viewpoint of reducing copper oxide and promoting sintering of copper in a subsequent sintering step, the content of copper hydride (CuH) is preferably 0.1% by mass or more and 1% by mass or less with respect to the total amount of the ink.

A method for measuring the content of copper hydride (CuH) is not particularly limited and can be appropriately selected depending on the purpose. For example, the content of copper hydride (CuH) can be measured by thermal desorption spectroscopy or the like.

As the copper hydride (CuH), a commercially available product may be appropriately used. Further, the copper hydride (CuH) may be synthesized with reference to Lousada CM, Fernandes RMF, Tarakina NV, Soroka IL. Synthesis of copper hydride (CuH) from CuCO₃ Cu(OH)₂ a path to electrically conductive thin films of Cu. Dalton Trans. 2017 May 23;46(20):6533-6543. doi: 10.1039/c7dt00511c. PMID: 28379275, or the like.

### -Reducing Agent-

The ink may contain a reducing agent other than the above copper hydride (CuH) as necessary.

The reducing agent is not particularly limited and can be appropriately selected depending on the purpose. Examples thereof include, but are not limited to, amine compounds.

Examples of the amine compounds include, but are not limited to, 2-amino-1-butanol, 1-amino-2-propanol, 2-amino-2-ethyl-1,3-propanediol, 2-amino-2-hydroxymethyl-1,3-propanediol, 1,3-diamino-2-propanol, 1-amino-2-butanol, and 2-aminoethanol.

These may be used alone or in combination of two or more.

### -Oxidizing Agent-

The ink may contain an oxidizing agent as necessary.

The oxidizing agent is not particularly limited and can be appropriately selected depending on the purpose. Examples thereof include, but are not limited to, phosphorus-containing compounds. Examples of the phosphorus-containing compounds include, but are not limited to, phosphorous acid, phosphoric acid, hypophosphorous acid, pyrophosphoric acid, tripolyphosphoric acid, tetrapolyphosphoric acid, trimetaphosphoric acid, phosphoric anhydride, and polyphosphoric acid. Among these, hypophosphorous acid is preferable.

These may be used alone or in combination of two or more.

Hypophosphorous acid oxidizes copper contained in the ink to generate copper hydride. When hypophosphorous acid is contained in the ink, copper hydride is decomposed to generate hydrogen during the sintering step, so that the reduction reaction of copper oxide is promoted.

The content of hypophosphorous acid is not particularly limited and can be appropriately selected depending on the purpose, but the weight ratio of hypophosphorous acid to copper is preferably 0.5% by mass or more and 80% by mass or less.

As the hypophosphorous acid, an appropriately synthesized one may be used, or a commercially available product may be used.

Examples of commercially available products of hypophosphorous acid include, but are not limited to, hypophosphorous acid solution (manufactured by Sigma-Aldrich Co. LLC, Nippon Chemical Industrial Co., Ltd.).

### -Other Components-

Other components are not particularly limited and can be appropriately selected depending on the purpose. Examples thereof include, but are not limited to, solvents.

The solvent is not particularly limited and can be appropriately selected depending on the purpose. Examples thereof include, but are not limited to, water, terpineol, ethylene glycol monomethyl ether, ethylene glycol monoethyl ether, ethylene glycol monopropyl ether, ethylene glycol monoisopropyl ether, ethylene glycol monobutyl ether, ethylene glycol monophenyl ether, ethylene glycol monobenzyl ether, ethylene glycol monohexyl ether, diethylene glycol monomethyl ether, diethylene glycol monoethyl ether, diethylene glycol mono-n-butyl ether, diethylene glycol monohexyl ether, ethylene glycol monomethyl ether acetate, ethylene glycol monoethyl ether acetate, ethylene glycol monopropyl ether acetate, ethylene glycol monoisopropyl ether acetate, ethylene glycol monobutyl ether acetate, ethylene glycol monophenyl ether acetate, ethylene glycol monobenzyl ether acetate, ethylene glycol monohexyl ether acetate, diethylene glycol monomethyl ether acetate, diethylene glycol monoethyl ether acetate, diethylene glycol mono-n-butyl ether acetate, diethylene glycol monohexyl ether acetate, diethylene glycol n-butyl ether acetate, propylene glycol, dipropylene glycol methyl ether, and tripropylene glycol methyl ether.

These may be used alone or in combination of two or more.

The content of the solvent is not particularly limited and can be appropriately selected depending on the purpose, and can be appropriately selected depending on the print pattern forming means and application.

A method or means for forming the print pattern is not particularly limited and can be appropriately selected depending on the purpose. Examples thereof include, but are not limited to, a spin coating method, a screen printing method, a spray coating method, a roll coating method, a dispensing method, and an inkjet method. Among these, the inkjet method is preferable.

When the inkjet method is used as the method or means for forming the print pattern, the viscosity of the ink is not particularly limited and can be appropriately selected depending on the inkjet head, but is preferably 5 mPa·s or more and 30 mPa·s or less.

The print pattern is not particularly limited and can be appropriately selected depending on the application. Examples thereof include, but are not limited to, solid films, electrode patterns, geometric patterns, lines, characters, numbers, symbols, and electric circuits.

### <<Dried Film Forming Step and Dried Film Forming Means>>

The dried film forming step is a step in which the print pattern is heated and air is blown onto the print pattern to form a dried film.

The dried film forming means is a means for heating the print pattern and blowing air onto the print pattern. Note that the means for heating the print pattern may be referred to as a "heating means", and the means for blowing air onto the print pattern may be referred to as a "air-blowing means".

The dried film forming step can be suitably carried out by the dried film forming means.

The method for manufacturing a conductive film according to the present embodiment enables evaporation or drying of a solvent contained in a print pattern to be uniformly promoted without excessively raising a drying temperature, through the dried film forming step in which the heating means and the air-blowing means are combined. As a result, non-uniformity in resistance is suppressed and temperature control is enabled so as not to decompose copper hydride (CuH), thereby making it possible to obtain a conductive film having low resistance without reducing productivity.

The heating means is not particularly limited and can be appropriately selected depending on the purpose. Examples thereof include, but are not limited to, a heating mechanism of a stage included in the print pattern forming means.

The heating temperature by the heating means is not particularly limited and can be appropriately selected depending on the purpose. However, from the viewpoint of promoting drying of the print pattern, it is preferable to adjust the temperature such that the substrate temperature is 40°C or higher and 100°C or lower, and more preferably 55°C or higher and 75°C or lower.

The heating time by the heating means is not particularly limited and can be appropriately selected depending on the purpose, but is preferably 10 seconds or more and 30 minutes or less, and more preferably 1 minute or more and 5 minutes or less.

The air-blowing means is not particularly limited and can be appropriately selected depending on the purpose. Examples thereof include, but are not limited to, a dryer.

From the viewpoint of promoting drying of the print pattern, air blowing by the air-blowing means is preferably performed at a wind speed of 3 m/s or more, and more preferably at 9 m/s or more. When the wind speed of air blowing by the air-blowing means is within these ranges, variation in solvent vapor pressure is suppressed, non-uniformity in drying is reduced, and consequently, non-uniformity in resistance can also be reduced. The upper limit of the wind speed is preferably 36 m/s or less.

From the viewpoint of promoting drying of the print pattern, the air-blowing temperature by the air-blowing means is preferably at room temperature (25°C) or higher and 200°C or lower, and more preferably 65°C or higher and 165°C or lower. When the air-blowing temperature by the air-blowing means is within these ranges, evaporation is promoted by heating of the print pattern due to heat transfer from hot air, whereby the drying time can be shortened, and as a result, productivity is improved.

Note that these heating temperature, air-blowing temperature, heating time, and wind speed can be appropriately set depending on the film thickness of the print pattern, the solvent contained in the ink, and the like.

In the dried film forming step, it is preferable to blow air onto the surface on which the print pattern is formed, and to heat the surface opposite to the surface on which the print pattern is formed. For example, in a system in which the conductive film manufacturing apparatus includes a substrate transport mechanism and printing is performed simultaneously with transport of the substrate, this can be realized by heating the print pattern by a stage heating mechanism provided in the substrate transport mechanism and subjecting the print pattern to air blowing by an air-blowing means installed downstream of the substrate transport.

Since such an aspect can uniformly promote evaporation (drying) of the solvent contained in the print pattern without excessively raising the drying temperature, non-uniformity in resistance is suppressed, and temperature control is enabled so as not to decompose copper hydride (CuH), thereby making it possible to obtain a conductive film having low resistance without reducing productivity.

Further, by making the substrate transport speed in the print pattern forming step the same as the substrate transport speed in the dried film forming step, application to a roll-to-roll method is also possible.

In the dried film forming step, it is preferable to perform heating and drying simultaneously. Such an aspect can suppress the flow of the ink applied onto the substrate, and as a result, the formation accuracy of the conductive film is improved.

The print pattern forming step and the dried film forming step may be performed simultaneously. Such an aspect can suppress the flow of the ink applied onto the substrate, and as a result, the formation accuracy of the conductive film is improved.

As described above, in the layered structure forming step, the print pattern forming step and the dried film forming step are repeated to form a layered structure. In other words, a process in which a dried film is formed by drying each time one layer of the print pattern is formed is repeatedly performed to form a layered structure.

When ink is applied in a state where the dried film serving as a base layer is insufficient, non-uniformity in resistance may occur as a result of film thickness distribution caused by flow of the coating film. On the other hand, in the method for manufacturing a conductive film according to the present embodiment, since the print pattern forming step and the dried film forming step are repeated for each layer, it is considered that the copper particles in the dried film are in a dense and homogeneous state, and non-uniformity in resistance is suppressed.

### <Sintering Step, Sintering Apparatus>

The sintering step is a step of sintering the layered structure obtained by the layered structure forming step.

The sintering apparatus is a means for sintering the layered structure obtained by the layered structure forming step.

The sintering step can be suitably carried out by the sintering apparatus.

In the sintering step, by heating at a temperature equal to or higher than the heating temperature in the dried film forming step, a crystal structure of a conductive metal contained in the ink is changed and sintering is performed, thereby exhibiting conductivity.

The sintering means is not particularly limited and can be appropriately selected depending on the purpose, if the sintering means can sinter the layered structure. For example, the same apparatus as the dried film forming means can be used.

For example, when a hot plate is used as the sintering means, sintering can be performed by placing the layered structure on the hot plate heated to a predetermined temperature.

The sintering temperature in the sintering step is not particularly limited and can be appropriately selected depending on the purpose, but is preferably 200°C or higher and 300°C or lower, and more preferably 200°C or higher and 250°C or lower.

The sintering time in the sintering step is not particularly limited and can be appropriately selected depending on the purpose, but is preferably 1 minute or more and 30 minutes or less, and more preferably 1 minute or more and 5 minutes or less.

The sintering step may be performed in a closed state and in a narrow space.

When the layered structure is sintered in a closed state, a reducing agent contained in the layered structure evaporates to fill the interior of the closed container and remains on the surface of the substrate, thereby allowing the reduction reaction to proceed efficiently. Due to the efficient progression of the reduction reaction, sintering can be completed at a low temperature (e.g., 200°C to 250°C) and in a short time (e.g., 10 minutes or less).

In the sintering step, it is preferable to sinter a closed container in which the layered structure is enclosed in a chamber whose internal space is under an inert gas atmosphere. With such a configuration, unnecessary oxidation occurring during the sintering step can be suppressed.

An inert gas is not particularly limited and can be appropriately selected depending on the purpose. Examples thereof include, but are not limited to, N₂ gas, and Ar gas.

Here, the method for manufacturing a conductive film according to the present embodiment is described with reference to the drawings. However, the present embodiment is not limited to these embodiments in any way.

Note that, in each drawing, the same constituent components are denoted by the same reference numerals, and duplicated description thereof may be omitted. Further, the number, position, shape, and the like of the constituent members are not limited to those of the present embodiment, and may be set to a number, position, shape, and the like as desired to carry out the present embodiment.

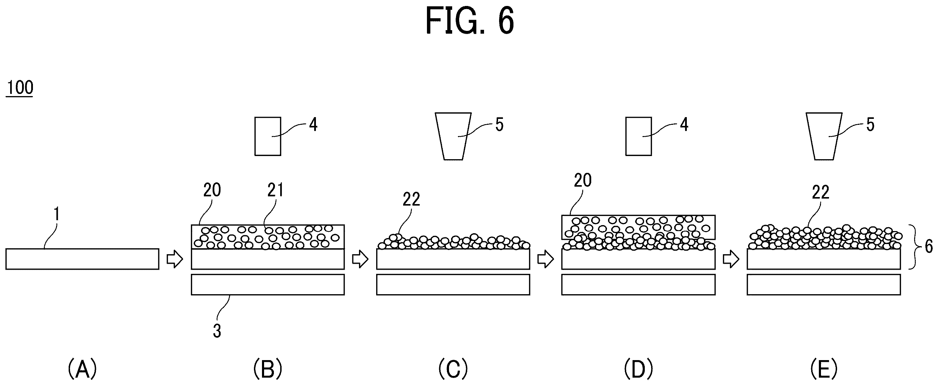

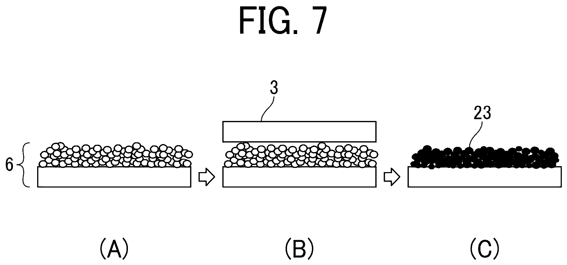

FIG. 6 is a schematic diagram for explaining an example of the layered structure forming step in the present embodiment. FIG. 7 is a schematic diagram for explaining an example of the sintering step in the present embodiment.

A layered structure forming device 100 as the layered structure forming means in FIG. 6 includes a heater 3, an inkjet head 4, and an air-blower 5 as the air-blowing means.

As illustrated in FIG. 6, an ink 20 containing copper particles 21 is applied from the inkjet head 4 as the print pattern forming means onto a substrate 1 to form a print pattern. At this time, heating is also performed from a surface opposite to the surface to which the print pattern is applied, by the heater 3 as the heating means. Note that the substrate 1 may be heated before the ink 20 is applied onto the substrate 1 (FIG. 6(A), (B)).

Next, air is blown onto the print pattern from the air-blower 5 installed downstream of the transport.

The print pattern is dried by heating by the heating means and air blowing by the air-blowing means, thereby forming a first dried film 22 (FIG. 6(C)).

The above series of operations is repeated to form a layered structure 6 having a desired thickness (FIG. 6(D), (E)).

As illustrated in FIG. 7(A)-(C), the layered structure 6 is sintered by the heater 3, which is also a sintering means, thereby forming a conductive film 23 (FIG. 7(A)-(C)).

In the method for manufacturing a conductive film according to the present embodiment, as described above, by including the layered structure forming step in which a layered structure is formed by repeating the print pattern forming step and the dried film forming step, and the sintering step of sintering the layered structure, a conductive film having low resistance and suppressed non-uniformity in resistance can be manufactured with high formation accuracy and high productivity.

### [Applications]

The conductive film obtained by the method for manufacturing a conductive film according to the present embodiment can be suitably adopted as an electromagnetic wave shield layer, an electrode pattern, a wiring pattern, and an antenna pattern.

When forming an electromagnetic wave shield layer on a semiconductor package, the conductive film is formed on the top surface and the side surface of the semiconductor package, and the conductive film and a ground (earth) wiring of the semiconductor package are connected with low impedance to form the electromagnetic wave shield layer.

For the electrode pattern, a desired electrode pattern is printed on a desired substrate.

### [Examples]

Hereinafter, the present embodiment will be specifically described with reference to Examples and Comparative Examples, but the present embodiment is not limited to these Examples in any way. Note that, in the following Examples and Comparative Examples, unless otherwise specified, "parts" represents "parts by mass", and "%" represents "% by mass".

### (Example 1)

### <Preparation of Ink>

As copper, Cu nanoparticles (NP) were used. A method for preparing the Cu nanoparticles is described in detail in Venkata Abhinav et al., RSC Advances, 2015, 5, 63985-64030.

The copper NP dispersion liquid was washed with an ultrafiltration membrane (CO = 100 KDa, PES). Using diethylene glycol monobutyl ether as a solvent, a composition containing 80% by mass of copper was prepared. The composition was filtered through a 1 µm syringe filter, 1.6% by mass of hypophosphorous acid (HPA) was added, and diethylene glycol monomethyl ether was added to prepare an ink containing 36% by mass of copper.

The viscosity of the ink was 11.7 mPa·s, and was measured using a rotary viscometer.

### <Preparation of Substrate>

As a substrate, an alkali-free glass substrate (manufactured by Corning Inc., Eagle XG, 40 mm × 40 mm × t0.7 mm) was used. This substrate was subjected to ultrasonic cleaning in a neutral detergent solution, then washed with running pure water and dried. Furthermore, in order to improve wettability, surface treatment by O₂ plasma treatment was performed.

### <Application>

Ink was applied to the substrate by an inkjet method. As the inkjet, MH5420 manufactured by Ricoh Company, Ltd. was used. The print pattern was a solid image having a recording density of 600 dpi × 600 dpi and an image size of 30 mm × 30 mm. Note that the stage was preheated, and the temperature conditions are illustrated in Table 4.

### <Drying>

A dryer was installed on the downstream side of the stage transport, and drying by air blowing was carried out continuously from the stage operation during printing. Conditions such as air-blowing temperature and wind speed are illustrated in Table 4.

The line speed was set such that the print pattern formed in one scan was dried by the time of the next scan by heating with the stage and air blowing with the dryer. Note that the faster a line speed V, the shorter the printing time, and high productivity can be realized. The evaluation criteria for productivity are as follows.

### -Evaluation Criteria-

A (Excellent): Line speed V is 100 mm/s or more
B (Good): Line speed V is 50 mm/s or more and less than 100 mm/s
C (Fair): Line speed V is less than 50 mm/s
D (Poor): Printing wait time occurs

These steps were repeated 4 times to obtain a layered structure of Example 1.

When the layered structure was analyzed by an ion chromatograph method and an X-ray diffraction method, a peak of hypophosphorous acid was detected by the ion chromatograph method, and a broad peak of CuH was detected by the X-ray diffraction method.

### <Sintering>

A polyimide film was pasted on the surface of the layered structure, and the layered structure was placed on a hot plate heated to 250°C and sintered to obtain a conductive film of Example 1. Sintering was performed in a chamber in an N₂ atmosphere, and the sintering time was 90 seconds.

### [Evaluation of Low Resistivity]

The conductivity of the obtained conductive film was evaluated, with volume resistivity as an index, using a sheet resistance meter employing a four-terminal method (manufactured by Nittoseiko Analytech Co., Ltd., Loresta MCP-T370 ("Loresta" is a registered trademark)). The evaluation criteria for volume resistivity are as follows.

### -Evaluation Criteria-

A (Excellent): Volume resistivity ρ is 10 µΩcm or less
B (Good): Volume resistivity ρ is more than 10 µΩcm and 30 µΩcm or less
C (Fair): Volume resistivity ρ is more than 30 µΩcm and 100 µΩcm or less
D (Poor): Volume resistivity ρ is more than 100 µΩcm

### (Examples 2 to 15)

A conductive film was produced and volume resistivity was evaluated in the same manner as in Example 1, except that the conditions were changed to those illustrated in Table 4. The results are illustrated in Table 4.

### (Examples 16 to 19)

A conductive film was produced and volume resistivity was evaluated in the same manner as in Example 1, except that the conditions were changed to those illustrated in Table 4 and the substrate was changed as follows. The results are illustrated in Table 4.

In Example 16, oil-proof paper FS (manufactured by Daio Paper Corporation) was used as the substrate.

In Example 17, oil-proof paper T-8 (manufactured by Ishizaki Shoji Co., Ltd.) was used as the substrate.

In Example 18, glassine paper (manufactured by PAPER Entrance, Model No. 55064) was used as the substrate.

In Example 19, coated paper (manufactured by Daio Paper Corporation, Utrillo Coat L) was used as the substrate.

### (Examples 20 to 25)

A conductive film was produced and volume resistivity was evaluated in the same manner as in Example 1, except that the preparation of the ink was changed as follows. The results are illustrated in Table 4.

### <Preparation of Ink>

As copper, Cu nanoparticles (NP) were used. A method for preparing the Cu nanoparticles is described in detail in Venkata Abhinav et al., RSC Advances, 2015, 5, 63985-64030.

The copper NP dispersion liquid was washed with an ultrafiltration membrane (CO = 100 KDa, PES). Using diethylene glycol monobutyl ether as a solvent, a composition containing 80% by mass of copper was prepared. The composition was filtered through a 1 µm syringe filter, 1.6% by mass of hypophosphorous acid (HPA) was added, and diethylene glycol monomethyl ether was added to prepare an ink containing 24% by mass of copper.

The viscosity of the ink was 7.1 mPa·s, and was measured using a rotary viscometer.

### (Comparative Examples 1 to 16)

A conductive film was produced and volume resistivity was evaluated in the same manner as in Example 1, except that the conditions were changed to those illustrated in Table 5.

Note that, when air-blowing by the air-blowing means is not performed, it is difficult to dry the print pattern in accordance with the stage line speed. Therefore, in Comparative Examples 1 to 4, 10, and 16, a layered structure was formed by forming the print patterns of the second and subsequent layers after waiting for the print pattern to dry after one scan. In Comparative Examples 5 to 7 and 11 to 15, the print patterns of the second and subsequent layers were formed without waiting for the print pattern to dry after one scan. The results are illustrated in Table 5.

**Table 4**

| Example | Stage Temperature [°C] | Dryer Air Velocity [m/s] | Dryer Air Temperature [°C] | Printing and Transport Line Speed [mm/s] | Printing Wait Time [sec] | Volume Resistivity [uΩcm] | Evaluation | |
|---|---|---|---|---|---|---|---|---|
| | | | | | | | Productivity | Low Resistance |
| Example 1 | 65 | 16.1 | 160 | 120 | 0 | 6.6 | A | A |
| Example 2 | 65 | 9.4 | 160 | 90 | 0 | 5.9 | B | A |
| Example 3 | 65 | 3.2 | 160 | 60 | 0 | 6.3 | B | A |
| Example 4 | 65 | 16.1 | 65 | 60 | 0 | 5.4 | B | A |
| Example 5 | 65 | 16.1 | 25 | 60 | 0 | 5.2 | B | A |
| Example 6 | 75 | 16.1 | 160 | 150 | 0 | 17.7 | A | B |
| Example 7 | 75 | 9.4 | 160 | 120 | 0 | 7.2 | A | A |
| Example 8 | 75 | 3.2 | 160 | 120 | 0 | 5.4 | A | A |
| Example 9 | 75 | 16.1 | 65 | 120 | 0 | 5.1 | A | A |
| Example 10 | 75 | 16.1 | 25 | 120 | 0 | 4.7 | A | A |
| Example 11 | 55 | 16.1 | 160 | 50 | 0 | 6.2 | B | A |
| Example 12 | 55 | 9.4 | 160 | 40 | 0 | 5.0 | C | A |
| Example 13 | 55 | 3.2 | 160 | 30 | 0 | 5.8 | C | A |
| Example 14 | 55 | 16.1 | 65 | 30 | 0 | 4.5 | C | A |
| Example 15 | 55 | 16.1 | 25 | 30 | 0 | 6.5 | C | A |
| Example 16 | 75 | 16.1 | 200 | 150 | 0 | 7.3 | A | A |
| Example 17 | 75 | 16.1 | 200 | 150 | 0 | 15.8 | A | B |
| Example 18 | 75 | 16.1 | 200 | 150 | 0 | 6.8 | A | A |
| Example 19 | 75 | 16.1 | 200 | 150 | 0 | 22.6 | A | C |
| Example 20 | 65 | 16.1 | 200 | 30 | 0 | 7.7 | C | A |
| Example 21 | 75 | 16.1 | 200 | 30 | 0 | 7.2 | C | A |
| Example 22 | 75 | 16.1 | 200 | 150 | 0 | 6.9 | A | A |
| Example 23 | 85 | 16.1 | 200 | 150 | 0 | 5.0 | A | A |
| Example 24 | 95 | 16.1 | 200 | 150 | 0 | 8.1 | A | A |
| Example 25 | 95 | 16.1 | 50 | 150 | 0 | 7.7 | A | A |

**Table 5**

| Comparative Example | Stage Temperatu re [°C] | Dryer Air Velocity [m/s] | Dryer Air Temperature [°C] | Printing and Transport Line Speed [mm/s] | Printing Wait Time [sec] | Volume Resistivity [uΩcm] | Evaluation | |
|---|---|---|---|---|---|---|---|---|
| | | | | | | | Productivity | Low Resistance |
| Comparative Example 1 | 65 | - | - | 150 | 60 | 6.3 | D | A |
| Comparative Example 2 | 75 | - | - | 150 | 30 | 5.6 | D | A |
| Comparative Example 3 | 85 | - | - | 150 | 20 | 5.5 | D | A |
| Comparative Example 4 | 95 | - | - | 150 | 10 | 6.3 | D | A |
| Comparative Example 5 | 65 | - | - | 150 | 0 | - | A | Not Measurable |
| Comparative Example 6 | 75 | - | - | 150 | 0 | - | A | Not Measurable |
| Comparative Example 7 | 85 | - | - | 150 | 0 | - | A | Not Measurable |
| Comparative Example 8 | 25 | 16.1 | 200 | 150 | 0 | - | A | Not Measurable |
| Comparative Example 9 | 25 | 16.1 | 200 | 30 | 0 | - | C | Not Measurable |
| Comparative Example 10 | 65 | - | - | 100 | 30 | 6.3 | D | A |
| Comparative Example 11 | 65 | - | - | 30 | 0 | - | C | Not Measurable |
| Comparative Example 12 | 75 | - | - | 30 | 0 | - | C | Not Measurable |
| Comparative Example 13 | 95 | - | - | 30 | 0 | 27.7 | C | C |
| Comparative Example 14 | 105 | - | - | 30 | 0 | 1505 | C | D |
| Comparative Example 15 | 75 | - | - | 100 | 0 | - | A | Not Measurable |
| Comparative Example 16 | 75 | - | - | 100 | 5 | 76.3 | D | C |

From the results of Examples 1 to 25, it can be seen that by drying the print pattern using a combination of the heating means and the air-bowling means, a conductive film having low resistance and suppressed non-uniformity in resistance can be manufactured with high formation accuracy and high productivity.

From the results of Comparative Examples 1 to 7 and 10 to 16, it can be seen that drying the print pattern only by the heating means leads to decreased productivity and increased resistance due to heating at a high temperature.

From the results of Comparative Examples 5 to 7 and 11 to 12, since the print patterns of the second and subsequent layers were formed without waiting for the print pattern of the first layer to dry, the coating film flowed, and measurement of volume resistivity was impossible.

From the results of Comparative Examples 8 to 9, when the print pattern was dried only by the air-blowing means without performing stage heating, the coating film was not sufficiently dried, and measurement of volume resistivity was impossible.

In Comparative Example 14, variation in volume resistivity was observed.

In Comparative Example 15, the volume resistivity at one point was extremely high, and measurement was impossible.

### (Example 26 and Comparative Example 17)

A conductive film was produced in the same manner as in Example 1, except that the conditions were changed to those illustrated in Table 6.

### [Evaluation of Low Resistivity]

Using a sheet resistance meter employing a four-terminal method (manufactured by Nittoseiko Analytech Co., Ltd., Loresta MCP-T370), the surface resistance was measured at a total of 5 points, the center and four corners of the conductive film. The results are illustrated in Tables 6 and 7.

**Table 6**

| Example | Stage Temperature [°C] | Dryer Air Velocity [m/s] | Dryer Air Temperature [°C] | Printing and Transport Line Speed [mm/s] | Printing Wait Time [sec] | Surface Resistance (1) [Ω/□] | Surface Resistance (2) [Ω/□] |
|---|---|---|---|---|---|---|---|
| Example 26 | 65 | 16.1 | 200 | 150 | 0 | 1.69E-02 | 1.70E-02 |
| Comparative Example 17 | 65 | - | - | 150 | 45 | 1.06E-01 | 3.34E-02 |

**Table 7**

| Example | Surface Resistance (3) [Ω/□] | Surface Resistance (4) [Ω/□] | Surface Resistance (5) [Ω/□] | Mean | Standard Deviation | Volume Resistivity (Mean) [uΩcm] | Productivity | Low Resistance |
|---|---|---|---|---|---|---|---|---|
| Example 26 | 1.89E-02 | 1.90E-02 | 1.67E-02 | 1.77E-02 | 1.15E-03 | 4.5 | A | A |
| Comparative Example 17 | 4.77E-02 | 6.76E-02 | 2.63E-02 | 5.62E-02 | 3.20E-02 | 19.3 | D | B |

From the results of Example 26, it can be seen that when the print pattern is dried by using a combination of the heating means and the air-bowling means, variation in surface resistance within the surface of the conducative film is small, and non-uniformity in resistance is seppressed.

From the results of Comparative Example 17, it can be seen that when the print pattern is dried only by the heating means, variation in surface resistance within the surface of the conductive film becomes large.

### (Examples 27 and 28)

### <Preparation of Ink>

As copper, Cu nanoparticles (NP) were used. A method for preparing the Cu nanoparticles is described in detail in Venkata Abhinav et al., RSC Advances, 2015, 5, 63985-64030.

The copper NP dispersion liquid was washed with an ultrafiltration membrane (CO = 100 KDa, PES). Using diethylene glycol monomethyl ether as a solvent, a composition containing 28.4% by mass of copper was prepared. The composition was filtered through a 1 µm syringe filter, and 1.6% by mass of hypophosphorous acid (HPA) was added thereto to prepare an ink.

The viscosity of the ink with a solvent content of 0.7 parts was 10.2 mPa·s, and was measured using a rotary viscometer.

### <Preparation of Substrate>

As the substrate, FS oil-proof paper (manufactured by Daio Paper Corporation) was used in Example 27, and glassine paper (manufactured by PAPER Entrance, Model No. 55064) was used in Example 28.

### <Application>

Ink was applied to the substrate by an inkjet method. As the inkjet, MH5420 manufactured by Ricoh Company, Ltd. was used. The print pattern was a solid image having a recording density of 600 dpi × 600 dpi and an image size of 30 mm × 30 mm. Note that the stage was preheated, and the temperature conditions are illustrated in Table 8.

### <Drying>

A dryer was installed on the downstream side of the stage transport, and drying by air blowing was carried out continuously from the stage operation during printing. Conditions such as air-blowing temperature and wind speed are illustrated in Table 8.

The line speed was set such that the print pattern formed in one scan was dried by the time of the next scan by heating with the stage and air blowing with the dryer. Note that the faster a line speed V, the shorter the printing time, and high productivity can be realized. The evaluation criteria for high productivity are as follows.

### -Evaluation Criteria-

A (Excellent): Line speed V is 100 mm/s or more
B (Good): Line speed V is 50 mm/s or more and less than 100 mm/s
C (Fair): Line speed V is less than 50 mm/s
D (Poor): Printing wait time occurs

These steps were repeated 4 times to obtain layered structures of Examples 27 and 28.

### <Sintering>

A polyimide film was pasted on the surface of the layered structure, and the layered structure was placed on a hot plate heated to 250°C and sintered to obtain a conductive film of Example 1. Sintering was performed in a chamber in an N₂ atmosphere, and the sintering time was 90 seconds.

### [Evaluation of Low Resistivity]

The conductivity of the obtained conductive film was evaluated, with volume resistivity as an index, using a sheet resistance meter employing a four-terminal method (manufactured by Nittoseiko Analytech Co., Ltd., Loresta MCP-T370). The evaluation criteria for volume resistivity are as follows.

### -Evaluation Criteria-

A (Excellent): Volume resistivity ρ is 10 µΩcm or less
B (Good): Volume resistivity ρ is more than 10 µΩcm and 30 µΩcm or less
C (Fair): Volume resistivity ρ is more than 30 µΩcm and 100 µΩcm or less
D (Poor): Volume resistivity ρ is more than 100 µΩcm

### [Method for Measuring Penetration Drying Time T of Solvent]

The penetration drying time T of the solvent was measured using a high-speed microscope camera (manufactured by Keyence Corporation, VW-6000) at 1000 frames per second, as the time until 30 pL of the solvent droplet applied onto the substrate disappeared from the substrate. The results are illustrated in Table 8.

### [Method for Measuring Contact Angle θ of Ink with Respect to Substrate]

The contact angle θ of the ink with respect to the substrate was measured with a contact angle meter DMs-301 (manufactured by Kyowa Interface Science Co., Ltd.). At this time, the droplet was 0.5 µL to 0.6 µL. The results are illustrated in Table 8.

### [Method for Measuring Conductivity (IACS)]

Measurement was performed in accordance with part of the resistivity test method employing a four-probe method for conductive plastics specified in JIS K 7194:1994. As illustrated in Table 8, a current I was passed between AD in needles A to D placed on an electronic component, a potential difference V between BC was measured, and the ratio thereof was multiplied by a correction factor RCF to obtain a sheet resistance ρs. The value of 4.532, which is obtainable even when an infinite plane is assumed, was used as the RCF. A low resistivity meter Loresta MCP-T380 (manufactured by Nittoseiko Analytech Co., Ltd.), which is a simplified model, and a PSP probe with a pin interval of 1.5 mm were used.

Next, a film thickness t of the electronic component was measured from cross-sectional observation of the sample. At this time, three cross sections were measured, and the average value thereof was taken as the film thickness t.

Using the following Formula II, a volume resistivity ρv and conductivity, which is the reciprocal thereof, were calculated. Note that the conductivity (IACS) was determined by taking the conductivity of International Annealed Copper Standard (volume resistivity 1.7241 × 10⁻⁸ Ωm) as 100%. The results are illustrated in Table 8. $ρ v = V / I \times RCF \times t = ρ s \times t$

### [Applicability to Formula I]

It was confirmed whether or not the combination of the solvent and the substrate satisfies the condition of the above Formula I. The evaluation criteria for applicability of Formula I are as follows.

### -Evaluation Criteria-

O: The condition of Formula I is satisfied
X: The condition of Formula I is not satisfied

**Table 8**

| Example | Stage Temperature [°C] | Dryer Air Velocity [m/s] | Dryer Air Temperature [°C] | Printing and Transport Line Speed [mm/s] | Printing Wait Time [sec] | Volume Resistivity [uΩcm] | Productivity | Low Resistance | Contact Angle θ (° ) | Penetration Drying Time T of Solvent (s) | Solvent Content Ratio | Right-hand Side Value of Formula I | Conductivity (IACS) [%] | Applicability to Formula I |
|---|---|---|---|---|---|---|---|---|---|---|---|---|---|---|
| Example 27 | 75 | 16.1 | 200 | 150 | 0 | 14.4 | A | B | 59 | 19 | 0.7 | 98 | 12.0 | ○ |
| Example 28 | 75 | 16.1 | 200 | 150 | 0 | 6.5 | A | A | 20 | 7.8 | 0.7 | 74 | 26.6 | ○ |

From the results of Examples 27 and 28, it can be seen that by drying the print pattern using a combination of the heating means and the air-blowing means, a conductive film having low resistance and suppressed non-uniformity in resistance can be manufactured with high formation accuracy and high productivity. Also, both Examples 27 and 28 satisfy the condition of the above Formula I, and it can be seen that a conductive film having low resistance can be manufactured by using a combination of a solvent and a substrate satisfying the above Formula I. In particular, it can be seen that glassine paper is preferable.

Aspects of the present embodiment are, for example, as follows.
<1> In a first aspect, a method for manufacturing a conductive film includes:
   forming a layered structure by repeating: forming a print pattern by applying an ink containing copper and copper hydride (CuH) onto a substrate; and forming a dried film by heating the print pattern and blowing air onto the print pattern; and
   sintering the layered structure.
<2> According to a second aspect, in the method according to the first aspect, the forming the dried film includes blowing air onto a surface on which the print pattern is formed, and heating a surface opposite to the surface on which the print pattern is formed.
<3> According to a third aspect, in the method according to the first or second aspect, the forming the print pattern includes heating the print pattern.
<4> According to a fourth aspect, in the method according to any one of the first to third aspects, the forming the dried film includes blowing air at a wind speed of not less than 3 m/s.
<5> According to a fifth aspect, in the method according to any one of the first to fourth aspects, the forming the dried film includes blowing air at an air-blowing temperature of not less than room temperature and not more than 200°C.
<6> According to a sixth aspect, in the method according to any one of the first to fifth aspects, the forming the dried film includes heating the substrate at not less than 55°C.
<7> According to a seventh aspect, in the method according to any one of the first to sixth aspects, the substrate is paper.
<8> According to an eighth aspect, in the method according to any one of the first to sixth aspects, the substrate is glassine paper.
<9> According to a ninth aspect, in the method according to any one of the first to seventh aspects, the ink contains hypophosphorous acid.
<10> In a tenth aspect, a conductive film is manufactured by the method according to any one of the first to ninth aspects.

According to the method for manufacturing a conductive film according to any one of the first to ninth aspects and the conductive film according to the tenth aspect, it is possible to solve the various problems in the related art and achieve the object of the present embodiment.

Any one of the above-described operations may be performed in various other ways, for example, in an order different from the one described above.

## Claims

1. A method for manufacturing a conductive film (23), the method comprising:
forming a layered structure (6) by repeating:
forming a print pattern by applying an ink (20) containing copper and copper hydride onto a substrate (1); and
forming a dried film (22) by heating the print pattern and blowing air onto the print pattern; and
sintering the layered structure (6).

2. The method according to claim 1, wherein the forming the dried film (22) includes:
blowing air onto a surface on which the print pattern is formed, and heating a surface opposite to the surface on which the print pattern is formed.

3. The method according to claim 1 or 2, wherein the forming the print pattern includes heating the print pattern.

4. The method according to any one of claims 1 to 3, wherein the forming the dried film (22) includes blowing air at a wind speed of not less than 3 m/s.

5. The method according to any one of claims 1 to 4, wherein the forming the dried film (22) includes blowing air at an air-blowing temperature of not less than room temperature and not more than 200°C.

6. The method according to any one of claims 1 to 5, wherein the forming the dried film (22) includes heating the substrate (1) to a temperature of not less than 55°C.

7. The method according to any one of claims 1 to 6, wherein the substrate (1) is paper.

8. The method according to any one of claims 1 to 6, wherein the substrate (1) is glassine paper.

9. The method according to any one of claims 1 to 8, wherein the ink (20) contains hypophosphorous acid.

10. A conductive film (23) manufactured by the method according to any one of claims 1 to 9.
